# EUROPEAN PATENT SPECIFICATION

(11) **EP 2 102 123 B1**
(45) Date of publication and mention of the grant of the patent: **17.04.2013**
(21) Application number: 07847044.0
(22) Date of filing: 10.12.2007
(51) Int. Cl.: C03C 1/00

(54) **CONDENSED MATERIALS**
KONDENSIERTE SUBSTANZEN
MATÉRIAUX CONDENSÉS

(30) Priority: 11.12.2006 GB 0624634
(43) Date of publication of application: 23.09.2009
(73) Proprietor: Westfälische Wilhelms-Universität Münster, 48149 Münster (DE)
(72) Inventor: BRACHT, Hartmut, 48149 Münster (DE); KNEBEL, Sebastian, 48149 Münster (DE)
(74) Representative: Harrison, Robert John
(86) International application number: PCT/EP2007/010747
(87) International publication number: WO 2008/071369

(56) References cited:
- EP-B- 1 113 987
- NOGAMI M ET AL: "SOL-GEL SYNTHESIS OF GE NANOCRYSTALS-DOPED GLASS AND ITS PHOTOLUMINESCENCE" JOURNAL OF SOL-GEL SCIENCE AND TECHNOLOGY, SPRINGER, NEW YORK, NY, US, vol. 9, no. 2, March 1997 (1997-03), pages 139-143, XP000683832 ISSN: 0928-0707
- CARPENTER J P ET AL: "Formation of crystalline germanium nanoclusters in a silica xerogel matrix from an organogermanium precursor" CHEMISTRY OF MATERIALS, vol. 8, no. 6, June 1996 (1996-06), pages 1268-1274, XP002473856
- YANG HEQING ET AL: "Photoluminescence of Ge nanoparticles embedded in SiO2 glasses fabricated by a sol-gel method" APPLIED PHYSICS LETTERS, AIP, AMERICAN INSTITUTE OF PHYSICS, MELVILLE, NY, US, vol. 81, no. 27, 30 December 2002 (2002-12-30), pages 5144-5146, XP012032922 ISSN: 0003-6951
- CHOI W K ET AL: "Observation of memory effect in germanium nanocrystals embedded in an amorphous silicon oxide matrix of a metal-insulator-semiconductor structure" APPLIED PHYSICS LETTERS, AIP, AMERICAN INSTITUTE OF PHYSICS, MELVILLE, NY, US, vol. 80, no. 11, 18 March 2002 (2002-03-18), pages 2014-2016, XP012030350 ISSN: 0003-6951
- ZHANG JIA-YU ET AL: "Electroluminescence and carrier transport of SiO2 film containing different density of Ge nanocrystals" APPLIED PHYSICS LETTERS, AIP, AMERICAN INSTITUTE OF PHYSICS, MELVILLE, NY, US, vol. 74, no. 17, 26 April 1999 (1999-04-26), pages 2459-2461, XP012022487 ISSN: 0003-6951

## Description

### Introduction

The functional properties of materials such as crystalline elemental and compound semiconductors, ion conducting homogeneous and nanostructured glasses, and silica layers are strongly affected by defects. The understanding about the properties of defects is of fundamental significance for the fabrication of materials with desired features. These defects may be for example group IV nanocrystals that are embedded in SiO₂. In the past, one focus has been on silicon nanocrystals in SiO₂, but also germanium nanocrystals have been studied. Nanocrystals of this kind show at least two interesting effects. Firstly, it could be shown that nanocrystals can serve as efficient light emitters and are, therefore, interesting for optical applications. Secondly, compatibility with silicon-based electronics can be maintained when using these materials which is of particular interest when the nanoparticles are to be created in a thin film applied to the silicon-based electronic.

### Prior Art

A number of methods for producing nanoparticles in oxide films are known. These methods typically need technically sophisticated equipment and are relatively cost-intensive.

Films that were created by sputtering and heat treatment were reported by Jensen et al. in "Ge nanocrystals in magnetron sputtered SiO2", Appl. Phys. A 83, 41 - 48 (2006), and by Kan et al. in "Effect of annealing profile on defect annihilation, crystallinity and size distribution of germanium nanodots in silicon oxide matrix", Appl. Phys. Lett. 83, 2058 (2003). In both papers the production of germanium nanodots by sputtering SiO₂ and Ge at the same time and subsequent thermal annealing is described.

Molecular beam epitaxy (MBE) was reported by Kanjilal et al. in "Structural and electrical properties of silicon dioxide layers with embedded germanium nanocrystals grown by molecular beam epitaxy", Appl. Phys. Lett. 82, 1212 (2003). This paper describes the fabrication of crystalline Ge-nanodots in amorphous SiO₂ by MBE and subsequent rapid thermal processing under oxidizing and reducing atmospheres. This method allows to produce a sheet with defined distance to the substrate that contains all dots.

Chemical vapor deposition (CVD) is described by Agan et al. in "Synthesis and size differentiation of Ge nanocrystals in amorphous SiO2", Appl. Phys. A 83, 107 - 110 (2006), and by Kanoun et al. in "Charging effects in Ge nanocrystals embedded in SiO2 matrix for non volatile memory applications", Materials Science and Engineering C 26 (2006) 360 - 363. In the first paper by Agan et al. a mixed SiO₂-GeO₂ glass is produced by plasma enhanced CVD and subsequent heat treatment in an inert gas atmosphere. The second paper by Kanoun et al. describes the fabrication of germanium nanocrystals on Si nuclei that were deposited firstly on a SiO₂ surface.

Ion implantation is described by Markwitz et al. in "Microstructural investigations of ion beam synthesized germanium nanoclusters embedded in SiO2 layers", Nuclear Instruments and Methods in Physics Research B 142 (1998) 338 - 348, and by Bonafos et al. in "An electron microscopy study of the growth of Ge nanoparticles in SiO2", Appl. Phys. Letters 76, 3962. Both papers describe the fabrication of Ge nanodots embedded in SiO₂ by implantation of Ge⁺ ions in a SiO₂ layer and subsequent thermal annealing.

Nogami et al. proposed a sol-gel process for the synthesis of Ge nanodots in sol-gel derived massive bulk glasses by thermal annealing in a reducing atmosphere in *"*Sol-gel method for synthesizing visible photoluminescent nanosized Ge-crystal-doped silica glasses", Appl. Phys. Lett. 65 (20) 2545. However, this paper does not consider Ge nanodot formation in thin films. The same is true for European Patent EP 1 113 987 B1, because it is directed at the formation of thick films, i.e. films that are thicker than 1 µm.

### Summary of the Invention

The method suggested by the inventors for synthesis of germanium nanoparticles in thin SiO₂ films is presented in claim 1.

Accordingly, the method implements the sol-gel route to produce thin layers of glasses with Ge-nanoparticles, i.e. germanium nanoparticles. The method allows the generation of nanoparticles from materials of which the oxides are less stable than the matrix. The wet chemical based sol-gel technique is technologically simple and a fast method to produce germanium nanoparticles and, in particular, germanium nanocrystals. The method does not require technically sophisticated equipment, as it is the case for other proposed routes to synthesise germanium nanocrystals in silicon dioxide, such as ion implementation, chemical vapor deposition (CVD), sputter deposition, or molecular beam epitaxy (MBE). The preparation of nanoparticles in SiO₂ with the sol-gel technique and a subsequent appropriate treatment is easily manageable and by far less cost-intensive than the other preparation techniques.

The term "glass" also comprises gels.

TEOS reacts with water to SiO₂ networks under the influence of H⁺-ion and alcohol (methyl- or higher alcohols) concentrations. This reaction is usually named condensation. It can be easily observed, because the condensated TEOS forms a network that leads to a stiff gel. The germanium tetraethoxide decomposes rapidly to germanium dioxide (GeO₂) and hydrochloric acid (HCl).

The process for the production of the germanium nanoparticles comprises the selected reduction of germanium and its segregation to nanospheres. The term "selected reduction" or "selectively reducing" means that the reduction affects mostly the germanium dioxide and not (or hardly) the silicon dioxide. This is due to the fact that SiO₂ is much more stable towards reduction than GeO₂.

The consolidation may comprise heating the substrate, i.e. it is a heat treatment. The consolidation serves several aims:
- The water and the ethanol should be removed.
- The residual carbon hydrates should be oxidized and removed.
- The porous glass is sintered.

After the heat treatment the glass cannot be removed by usual solvents such as acetone or ethanol. In contrast, the unconsolidated layers can be removed with little mechanical grating by acetone.

During consolidation, the substrate may be heated under oxidizing atmosphere above 400°C. For example, the coated substrate is heated under air atmosphere up to 600°C with heating rates below 1°C/min.

The application may comprise spin coating the solution to the surface of the substrate. Spin coating of the solution to the surface of the substrate produces a thin and homogeneous film on the surface. Other methods of applying the solution to the surface may also be contemplated.

A condensation speed of TEOS and germanium tetraethoxide may be controlled by the H⁺-ion concentration via the pH value of the solution. Controlling the H⁺-ion concentration of the solution provides an indirect control facility that is usually easy to manipulate.

The reduction may be performed under a gas atmosphere consisting of hydrogen and inert gas at temperatures between 800°C and 1200°C. The heat treatment reduces a high part of the germanium dioxide without reducing the silicon dioxide. This may be achieved by optimizing the heat treatment which also serves for controlling the size of the germanium nanocrystals. It is also possible to add a second annealing phase under inert gas atmosphere or under a vacuum. The used gas mixture is well suited for industrial applications because it is not as explosive as pure hydrogen.

The substrate may be a silicon substrate. Silicon is suited as substrate material since SiO₂ is much more stable towards reduction than GeO₂. Therefore, SiO₂ is not reduced in noteworthy amounts during the reduction phase. The first SiO₂ layer is not affected by the reduction.The silicon dioxide film containing the nanocrystals may be regarded as an electrical structure or component. Circuits for connecting this electrical structure with other electrical or electronic components may be formed in the silicon, for example by means of known lithography methods. It may also be contemplated to form e.g. driving electronics for the electrical structure in the silicon matrix.

The method comprises
- preparing an additive solution comprising diethoxydimethylsilane and ethanol;
- adding said additive solution to said solution that comprises Tetraethoxyorthosilane, germaniumtetraethoxide or germanium esters, ethanol, and water.

The presence of hydrolyzed diethoxydimethylsilane lowers the condensation rate of hydrolyzed germaniumtetraethoxide. The additive prevents the solutions containing useful concentrations of Ge(OC₂H₅)₄ from geling too fast, thereby making it suitable for a subsequent coating procedure.

The invention is also directed at a product that is produced according to the method described above.

The invention is furthermore directed at such a device that comprises a substrate having a first layer of silicon dioxide on the surface of the substrate and a second layer of silicon dioxide with germanium nanocrystals. The silicon dioxide of the first layer is a dielectric material that prevents unwanted electron flow.

The first layer of SiO₂ develops when the sol-gel layer is consolidated. A thinner first layer can be obtained, if the duration of the heat treatment is shortened, the peak temperature of the heat treatment is decreased, or the oxygen content is reduced during the consolidation phase.

The second layer may have a thickness from 20 nm to 200 nm. The size of the germanium nanocrystals may be smaller than 20 nm. In order for the second layer to have the desired effects, it is important that the nanocrystals have a certain average size and maintain a certain distance to each other and to the silicon substrate. The embedded nanocrystals represent a deep potential well within the dielectric matrix. Especially for quantum-sized particles a behavior can be observed that is much different from the bulk crystal.

The invention is also directed at a non-volatile memory, an optical switch, a photoluminescence device, or a capacitor made from the device described above.

One example of a non-volatile memory is a field effect transistor (FET) in which the germanium nanoparticles are disposed in the control oxide between the gate and the channel of the field effect transistor. A thin tunneling oxide separates the inversion surface of an n-channel silicon field-effect transistor from a distributed film of nanoparticles that covers the entire surface channel region. A thicker tunneling oxide separates the nanoparticles from the control gate of the FET. The non-volatile memory device formed in this manner utilizes direct tunneling and storage of electrons in three-dimensionally confined nanoparticles. The effect of the germanium nanoparticles is comparable to the effect of a floating gate. In particular, bi-stability in the conduction of the transistor channel is achieved. The fabrication of a non-volatile memory cell requires control of four main parameters: (i) the tunnel oxide thickness, (ii) the nanocrystal density, (iii) the nanocrystal diameter, and (iv) the control oxide thickness. This is, to a large extent, possible, if the film structure of the non-volatile memory is obtained through the method proposed in this application.

Silicon dioxide glasses with embedded germanium nanoparticles also have potentials for non-linear optical devices. When small-sized semiconductor particles are embedded in the dielectric matrices, the wave functions of photoexcited electron-hole carriers and excitons are confined in a deep potential well of the matrix.

### Description of the Drawing

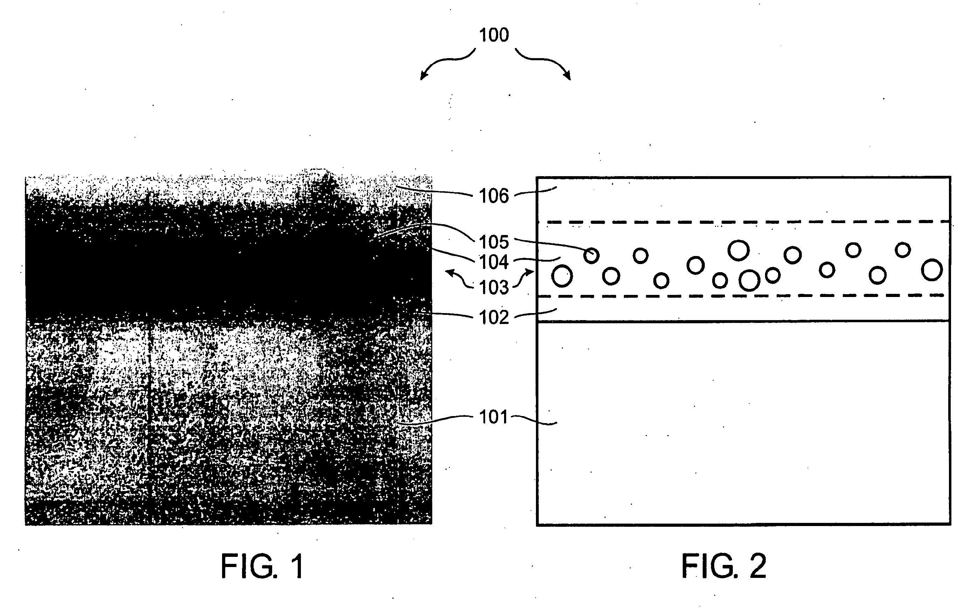

Figs. 1 and 2 show a cross section through a structure 100 obtained with the method proposed by the inventors. Fig. 1 shows a transmission electron photo of an actually produced structure 100. Fig. 2 schematically shows the layers of structure 100. The structure is based on substrate 101 which in the present case is silicon. A layer 102 of silicon dioxide is situated on top of substrate 101. This layer 102 is exempt from germanium nanoparticles and may serve as a tunneling oxide. On top of layer 102 is situated a layer 103 of silicon dioxide 104 with embedded germanium nanoparticles 105. Another layer 106 of silicon dioxide that is exempt from germanium nanoparticles is found on top of layer 103. All three layers 102, 103, and 106 are formed during the heat treatment which include the consolidation and reduction treatment. In a non-volatile memory device this layer 106 may serve as control oxide, i.e. it is interposed between e.g. a control gate of a field effect transistor and layer 103 containing the nanoparticles 105.

### Example 1 (reference)

Tetraethoxyorthosilane (TEOS), germaniumtetrachloride (GeCl₄) and ethanol in at least p.a.-purity and highly purified water were used as starting materials. The solution was spin-coated in order to form homogeneous layers. The coated substrates are heated under air atmosphere up to 600°C with heating rates below 1°C/min. Selected reduction of germanium and its segregation to nanospheres took place under a gas atmosphere consisting of 10 vol% hydrogen and 90 vol% nitrogen at 1000°C for several hours. Under this condition germanium precipitated in form of spheres that were embedded in the glass. The heat treatment needed to be optimized in order to reduce a high part of the germanium dioxide without reducing the silicon dioxide and to control the size of the germanium nanoparticles. The nanoparticles were about 5nm in diameter. The layer of silicon dioxide in immediate contact with the silicon substrate that was exempt from germanium nanoparticles measured about 8 nm in thickness. The layer of silicon dioxide containing the germanium nanoparticles measured about 40 nm in thickness.

### Example 2

Tetraethoxysilane, germaniumtetraethoxide Ge(OC₂H₅)₄, ethanol, diethoxydimethylsilane (CH₃)₂Si(OC₂H₅)₂, hydrochloric acid (HCl), and highly purified water were used here as starting materials.

The diethoxydimethylsilane was diluted with ethanol. Then it was hydrolyzed with water and hydrochloric acid for several hours. The hydrolysis was done under continuous stirring in a closed bottle at 5°C. Afterwards a part of the solution described above and water were added to a solution consisting of tetraethoxysilane, germaniumtetraethoxide and ethanol. This new solution was aged for several hours under the same conditions that were applied for the hydrolysis of diethoxydimethylsilane as described above. Slices of silicon wafers were dip coated with this solution. The thermal treatment was the same as used in example
1. The presence of hydrolyzed diethoxydimethylsilane lowers the condensation rate of hydrolyzed germaniumtetraethoxide. Without this additive the solutions containing useful concentrations of Ge(OC₂H₅)₄ gelate too fast for any coating procedure.

## Claims

1. Method for synthesis of germanium nanoparticles in thin SiO₂ films comprising:
preparing a solution comprising Tetraethoxy-orthosilane (TEOS), germaniumtetraethoxide, ethanol, and water; preparing an additive solution comprising diethoxydimethylsilane and ethanol; adding said additive solution to said solution; applying the solution to a surface of a substrate; consolidating the solution on the surface of the substrate, thereby obtaining a glass comprising silicon dioxide and germanium dioxide; selectively reducing the germanium dioxide to form germanium nanoparticles
wherein the thin SiO₂ films have a thickness of about 20 nm to about 200 nm.

2. Method of claim 1, wherein the consolidation comprises heating the substrate.

3. Method of claim 2, wherein said substrate is heated under oxidizing atmosphere above 400°C.

4. Method of any one of claims 1 to 3, wherein said application comprises spin coating said solution to the surface of said substrate.

5. Method of any one of claims 1 to 4, wherein a condensation speed of TEOS and germanium tetraethoxide is controlled by the H⁺-ion concentration of the solution.

6. Method of any one of claims 1 to 5, wherein said reduction is performed under a gas atmosphere consisting of hydrogen and inert gas at temperatures between 800°C and 1200°C.

7. The method of any one of the above claims, wherein the substrate is a silicon substrate.

## Patentansprüche

1. Verfahren für die Herstellung von Germanium-Nanopartikeln in dünnen SiO₂ Filmen umfassend:
Vorbereiten einer Lösung, welche Tetraethoxy-Orthosilan (TEOS), Germaniumtetraethoxid, Ethanol und Wasser umfasst; Vorbereiten einer Zusatzlösung, welche Diethoxydimethylsilan und Ethanol umfasst; Hinzufügen der Zusatzlösung zu der Lösung; Aufbringen der Lösung auf eine Oberfläche eines Substrats; Festwerden der Lösung auf der Oberfläche des Substrats, so dass ein Glas erhalten wird, welches Siliziumdioxid und Germaniumdioxid umfasst; selektiv Reduzieren des Germaniumdioxids, um Germanium-Nanopartikel zu bilden,
wobei die dünnen SiO₂ Filme eine Dicke von etwa 20 nm bis etwa 200 nm haben.

2. Verfahren nah Anspruch 1, wobei das Festwerden Erhitzen des Substrats umfasst.

3. Verfahren nach Anspruch 2, wobei das Substrat unter oxidierender Atmosphäre über 400°C erhitzt wird.

4. Verfahren nach einem der Ansprüche 1 bis 3, wobei das Aufbringen Spin-Coating der Lösung auf die Oberfläche des Substrats umfasst.

5. Verfahren nach einem der Ansprüche 1 bis 4, wobei eine Kondensationsgeschwindigkeit von TEOS und Germaniumtetraethoxid durch die H⁺-Ionen-Konzentration der Lösung kontrolliert wird.

6. Verfahren nach einem der Ansprüche 1 bis 5, wobei die Reduktion unter einer GasAtmosphäre, welche aus Wasserstoff und Inertgas besteht, bei Temperaturen zwischen 800°C und 1200°C durchgeführt wird.

7. Verfahren nach einem der obigen Ansprüche, wobei das Substrat ein Silizium-Substrat ist.

## Revendications

1. Procédé de synthèse de nanoparticules de germanium dans des couches minces SiO₂, comprenant :
préparer une solution comprenant du tétraéthoxy-orthosilane (TEOS), du tétraéthoxyde de germanium, de l'éthanol, et de l'eau ; préparer une solution d'addition comprenant du diéthoxydiméthylsilane et de l'éthanol ; ajouter la solution d'addition à ladite solution ; appliquer la solution sur une surface d'un substrat ; consolider la solution sur la surface de substrat, et obtenir ainsi un verre comprenant du dioxyde de silicium et du dioxyde de germanium ; réduire sélectivement le dioxyde de germanium pour former des nanoparticules de germanium,
dans lequel les couches minces SiO₂ ont une épaisseur d'environ 20 nm à environ 200 nm.

2. Procédé selon la revendication 1, dans lequel la consolidation comprend le chauffage du substrat.

3. Procédé selon la revendication 2, dans lequel le substrat est chauffé dans une atmosphère oxydante sous 400 °C.

4. Procédé selon l'une quelconque des revendications 1 à 3, dans lequel l'application comprend le dépôt à la tournette de la solution sur la surface de substrat.

5. Procédé selon l'une quelconque des revendications 1 à 4, dans lequel une vitesse de condensation du TEOS et du tétraétoxyde de germanium est contrôlée par la concentration en ion H⁺ de la solution.

6. Procédé selon l'une quelconque des revendications 1 à 5, dans lequel la réduction est réalisée sous une atmosphère gazeuse comprenant de l'hydrogène et un gaz inerte à des températures comprises entre 800°C et 1200°C.

7. Procédé selon l'une quelconque des revendications précédentes, dans lequel le substrat est un substrat silicium.
